# EUROPEAN PATENT APPLICATION

(11) **EP 1 139 540 A1**
(43) Date of publication of application: **04.10.2001**
(21) Application number: 99943275.0
(22) Date of filing: 10.09.1999
(51) Int. Cl.: H02J 7/00, H01R 13/46, H01R 25/00, H01M 10/46

(54) **AC CHARGER**

(71) Applicant: SMK Corporation, Tokyo 142-8511 (JP)
(72) Inventor: MATSUDA, Takeshi, SMK Corporation, Tokyo 142-8511 (JP); MANO, Nobuyuki, SMK Corporation, Tokyo 142-8511 (JP)
(74) Representative: VOSSIUS & PARTNER
(86) International application number: JP9904945
(87) International publication number: WO0120747

(57) **Abstract**

An AC charger is provided which is handy to carry. Namely, the AC charger comprises a rectangular housing having an opened ceiling and a vertically bisected interior, a plug for being plugged in an AC receptacle, the plug being pivotally supported in an upper half interior of the housing for being allowed to be freely made stand and laid so as to be laid to be accommodated in the housing when not used and made stand to be projected upward from the housing when used, an AC to DC converting electric apparatus provided in a lower half interior of the housing, a connection structure for electrically connecting the AC to DC converting electric apparatus and the plug, and a device for distributing a DC voltage outputted from the AC to DC converting electric apparatus to other electronic devices, by which the plug is laid so as to be accommodated in the housing when the charger is not used and is made stand so as to be projected upward from the housing when used.

## Description

### Technical Field

The present invention relates to an AC charger, particularly to a small, simply constructed, inexpensive, and handily portable AC charger which allows an attachment plug to project from a housing in a case when the charger is used and to be accommodated in the case when not used.

### Background Arts

Recently, there is a trend for storage-battery-powered portable electronic devices to increase. Such electronic devices require AC chargers for charging the storage batteries thereof. In particular, when the storage-battery-powered portable electronic devices are carried to overseas countries, AC chargers are necessary for making the devices adaptable to receptacles of AC 200V in overseas countries.

As is well known, the AC charger comprises electric apparatuses such as a transformer and a rectifier for converting an AC voltage to a DC voltage, an attachment plug (hereinafter referred to as a plug) being plugged in a receptacle device for taking out an AC power source and supplying it to the above-described electric apparatuses, two connection wires for connecting the transformer to the plug, and a connection cable for supplying a DC voltage outputted from the rectifier to the electronic device.

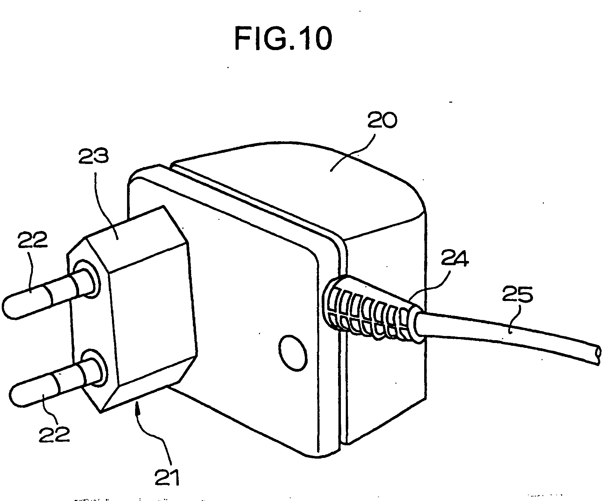

FIG. 10 shows an external view of a conventional general AC charger. In FIG. 10, the above-described AC to DC converting electric apparatuses is contained in a closed approximately rectangular housing 20. On one face of the housing 20, there is provided a plug 21 in upright position. The plug 21 comprises two metallic pins 22 and 22, and a pin holder 23 made of an insulator for holding the pins 22 and 22 in being uniformly spaced and maintaining mutual insulation thereof. The pins 22 and 22 project in the inserting direction and are studded on the pin holder 23 swingably.

The pins 22 and 22 with such structures are inserted into a receptacle not shown under regulation of the positions.

From one end of the housing 20, there extends a cable 25 that outputs DC voltage via a bushing 24.

Although what is shown in FIG. 10 is mere an example, what is common to conventional AC chargers is that they are of constructions in which the plugs 21 project from the housings 20.

However, one provided with plugs projecting from the housing like the above-described conventional AC charger, is particularly so unhandy to carry when traveling overseas as to become a problem.

Accordingly, the present invention has a subject in solving the above-described problem for realizing an AC charger with high portability with a small size, a simple structure, and a low cost.

### Disclosure of the Invention

In order to solve the above-described problem, an AC charger according to the present invention comprises a rectangular housing having an opened ceiling and a vertically bisected interior, a plug for being plugged in an AC receptacle, the plug being pivotally supported in an upper half interior of the housing for being allowed to be freely made stand and laid so as to be laid to be accommodated in the housing when not used and made stand to be projected upward from the housing when used, an AC to DC converting electric apparatus provided in a lower half interior of the housing, connection means for electrically connecting the AC to DC converting electric apparatus and the plug, and means for distributing a DC voltage outputted from the AC to DC converting electric apparatus to other electronic devices.

The AC charger according to the above-described constitution can accommodate the plug in the upper half interior of the housing by laying the plug when the charger is not used. Therefore, the charger provides a rectangular external view when not used to become handy to carry.

Moreover, the above-described plug of the AC charger according to the present invention has two pins for being plugged in the receptacle and a pin holder for embedding bases of the two pins, a rear end part of the pin holder being formed in a semicylindrical form and being pivotally supported by right and left side walls of the housing in being rotatable with an axis of the cylinder at the center.

In addition, the AC charger according to the present invention comprises plug-locking means for pressing the semicylindrical rear end part of the plug by a spring force to be engaged with the plug for fastening it when the above-described plug is made stand.

With the above-described structure, when the plug is made stand in time of using the AC charger, the plug is maintained in being made stand by the plug locking means.

Furthermore, the AC charger according to the present invention comprises lock-releasing means for releasing a lock to the standing plug by removing a pressing force of the spring of the above-described plug locking means. With this, when the AC charger is not used, the plug can be easily laid to be accommodated in the housing.

Additionally, as a specific structure of the above-described plug locking means of the AC charger according to the present invention, the plug locking means comprises two pieces arranged in parallel, and a pair of S-shaped leaf springs providing connection between the two pieces. One of the two pieces is secured to a rear part of the housing, and the other piece is made movable backward and forward.

With such structure, the movable piece of the plug locking means always applies a pressure on the plug to automatically lock the plug when the plug is made stand.

Moreover, the above-described lock releasing means comprises a lug attached to an upper face of the movable piece of the plug locking means. With the structure, by shifting the above-described movable piece against an elastic force of the springs with a finger catching the above-described lug, the movable piece is easily departed from the surface of the plug to allow the lock to be released.

In addition, the AC charger according to the present invention comprises means for holding the plug in time of being accommodated. The means for holding the plug in time of being accommodated comprises two hemisphere-like projections respectively formed on inside surfaces of right and left sidewalls of the above-described housing. The mutual distance of the two hemisphere-like projections is taken as being a little larger than a distance between outer sides of the two pins. Therefore, when moving the plug from the state of standing to that of being accommodated, the two pins can pass through between the two hemisphere-like projections while being in touch with the projections.

Furthermore, the connection means for electrically connecting the above-described AC to DC converting electric apparatus and the above-described plug of the AC charger according to the present invention is provided with two contacting pieces arranged on a surface of the semicylindrical rear end part of the above-described plug and respectively connected to the above-described two pins.

With the structure, the above-described two contacting pieces are made in slidable contact with electric contacts arranged at suitable positions.

### Brief Description of the Drawings

FIG. 1 is a perspective view of an example of an AC charger according to the present invention in time of being used;
FIG. 2 is a perspective view of the example in time of being not used;
FIG. 3 is a top view of the example in time of being not used;
FIG. 4 is a front view of the example in time of being not used;
FIG. 5 is a side cross sectional view of the example in time of being used;
FIG. 6 is a perspective view of a plug of the example in time of being used;
FIG. 7 is a perspective view of the plug of the example in time of being not used;
FIG. 8 is a perspective view of plug locking means of the example;
FIG. 9 is a perspective view showing the plug locking means of the example in a state of being mounted; and
FIG. 10 is an explanatory diagram of a conventional AC charger.

### Best Mode for Carrying Out the Invention

In the following, an example of the AC charger according to the present invention will be explained in detail by using drawings.

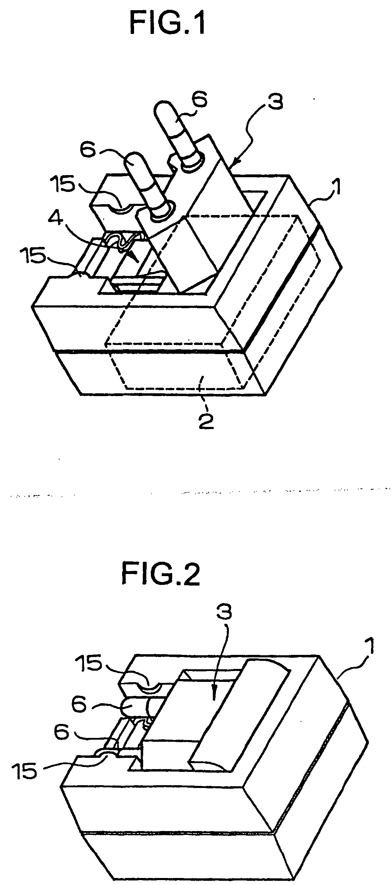

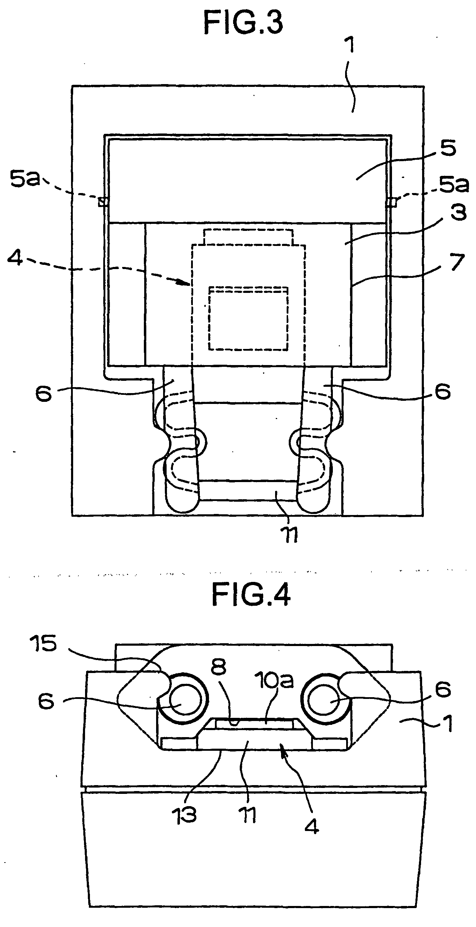

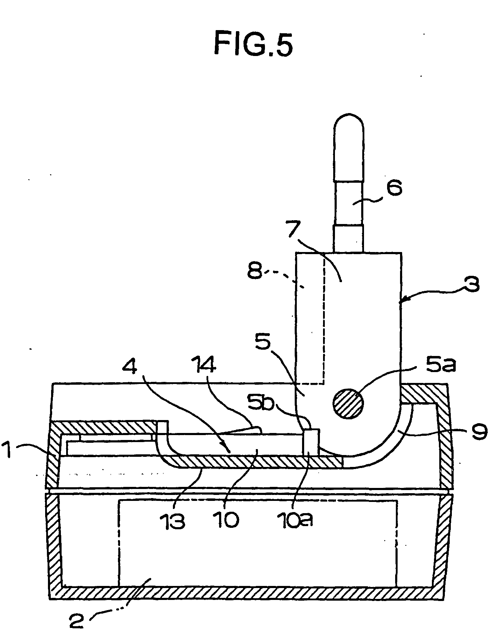

FIG. 1 is a perspective view of an example of an AC charger according to the present invention in time of being used, FIG. 2 is a perspective view in time of being not used, FIG. 3 is a top plan view in time of being not used, FIG. 4 is a front view in time of being not used, and FIG. 5 is a side cross sectional view in time of being used.

The AC charger according to the present invention comprises as shown in the figure a rectangular housing 1 having an opened ceiling and a vertically bisected interior, an AC to DC converting electric apparatus 2 provided in a lower half interior of the housing 1, a plug 3 provided in an upper half interior of the housing 1 as will be described later, and a plug locker 4 as plug locking means and plug lock releasing means provided in an upper half interior of the housing 1 as will be described later.

The plug 3 is pivotally supported on the sidewalls of the housing 1 for being allowed to be freely made stand and laid. When being made stand, the plug 3 is projected from an upper face of the housing 1 as shown in FIG. 1, and when being laid, the plug 3 is accommodated in the housing 1 as shown in FIG. 2.

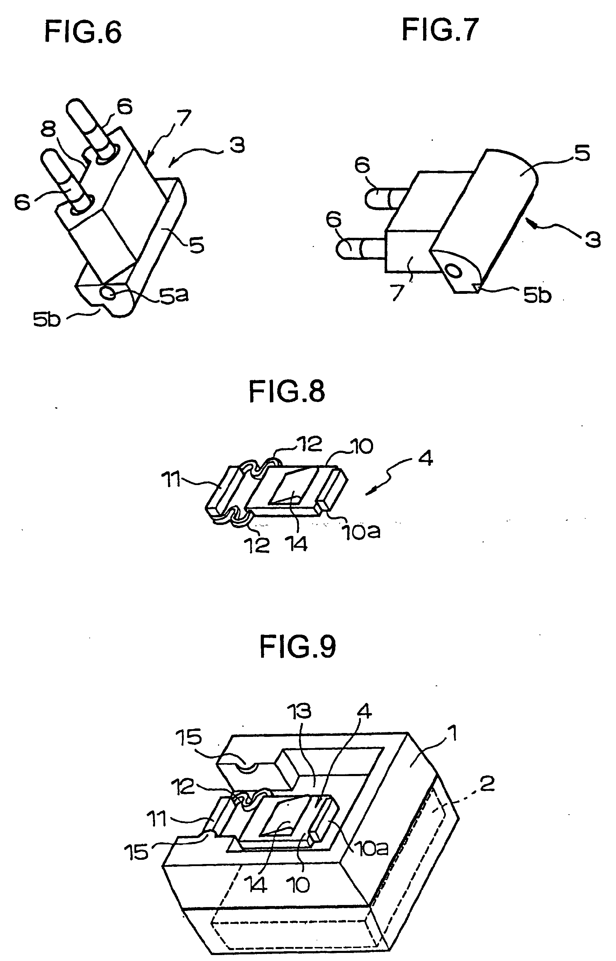

FIG. 6 and FIG. 7 show the plug 3 in a state of being made stand and in a state of being accommodated, respectively. As shown in the figures, the plug 3 comprises a semicylindrical component 5, two metallic pins 6 and 6,and a pin holder 7 in a form of a hexagonal prism provided in upright position on a section of the semicylindrical component 5. The pins 6 and 6 are studded on one end face of the pin holder 7 with a specified distance between them with tips thereof being made inclined in a direction of facing each other. The structure of the studded base of the pin is provided for allowing the tip of the pin to swing so that the tips of the pins are plugged in a receptacle to make positional restriction thereof possible. The pin holder 7 is made of an insulator so as to keep insulation between the pins 6 and 6.

As described above, since the lower end face of the plug 3 is formed in semicylindrical, when the plug is made stand on a plane as shown in FIG. 6, it is to be naturally upset as shown in FIG. 7.

On one face of the pin holder 7 in the form of the hexagonal prism of the plug 3, there is formed a rectangular recess 8 having an area larger than the size of the plug locker 4. This allows the lower face of the plug 3 to cause no collision with the plug locker 4 when the plug 3 is accommodated in the housing 1.

As shown in FIG. 3 and FIG. 5, the semicylindrical component 5 of the plug 3 is provided with rotational shafts 5a. The rotational shafts 5a are pivotally supported by bearings respectively provided on inner faces of right and left sidewalls in a front section of the upper housing 1. In addition, the semicylindrical component 5 is provided with a cutout 5b along the longitudinal direction of the cylindrical outer face. The cutout 5b is for making the plug 3 engaged and fastened in a standing state.

Moreover, as shown in FIG. 5, in the front section of the housing 1 (on the right in FIG. 5), there is provided a quadrant-shaped guide 9. The semicylindrical component 5 of the plug 3 is provided rotatable while being guided by the guide 9.

Rear ends of the pins 6 and 6 are electrically connected to unillustrated two contacting pieces provided on the lower end face of the semicylindrical component 5. Further, the contacting pieces are made so as to be electrically connected to input terminals of a transformer through an unillustrated printed circuit board when the plug is made stand.

The plug locker 4 is frictionally engaged with the semicylindrical component 5 when the plug 3 is accommodated and made stand to maintain a stable rotational movement, and along with this, is engaged with and fastens the plug 3 for keeping the standing state thereof so as not to be upset when the plug 3 is made stand. The plug locker 4, as shown in FIG. 8, comprises a rectangular plate block 10, a long thin square block 11 laid in parallel with the plate block 10, and two S-shaped leaf springs 12 and 12 connecting the plate block 10 and the square block 11. On a front end of the plate block 10, a block 10a is integrally formed which has a height larger than the thickness of the plate block 10.

The plug locker 4 is arranged on a bottom face of a depression 13 provided by opening the upper part of the housing I as shown in Fig. 9. The square block 11 is fixed at a rearmost section of the depression 13 with the plate block 10 and the leaf springs 12 and 12 being liberated. That is, the plate block 10 is energized in a direction of moving forward by elastic forces of the leaf springs 12 and 12.

A state when the plug 3 and the plug locker 4 are attached to respective specified positions with the plug 3 accommodated in the housing is presented as shown in FIG. 2, FIG. 3, and FIG. 4. At this time, the plug locker 4 is fitted in the recess 8 of the plug 3.

When the plug 3 is made stand in upright position, the plate block 10 of the plug locker 4 is out of the recess 8 of the plug 3 to apply a pressure on the rear face of the semicylindrical component 5 for being frictionally engaged therewith by stretching forces of the leaf springs 12 and 12 as show in Fig. 5. When the plug 3 in that state is made stand in upright position, the plug 3, rotationally moving with a specified frictional force being applied, performs a stable movement with further forward rotation prevented by the guide 9 and the front wall of the housing 1. At the same time, the rear face of the semicylindrical component 5 of the plug 3 is pressed by the front end of the block 10a at the plug locker 4. As a result, the plug 3 is allowed to be upset neither forward nor backward to be held in a standing state.

On the upper face of the plate block 10 of the plug locker 4, there is provided a projection 14 having an inclined face as a plug lock releasing means. By moving the plate block 10 backward against the elastic forces of the leaf springs 12 and 12 with a finger catching the projection 14, engaged fastening between the plate block 10 and the semicylindrical component 5 of the plug 3 is released. As a result, a standing up maintaining force for the plug 3 is lost, so that the plug 3 can be easily laid so as to be accommodated in the housing 1.

As shown in each of the drawings, the right and left sidewalls in the rear section of the housing 1 are protruded inward. At uppermost ends at the respective centers of the right and left protrusions, there are formed hemisphere-like projections 15 and 15. The distance between the projections 15 and 15 is taken as being a little larger than a distance between outer sides of the pins 6 and 6 of the plug 3. This makes the projections 15 and 15 in touch with the pins 6 and 6 when the standing plug 3 is laid to be accommodated in the housing 1, by which the pins 6 and 6 are bent inward to enter inside.

After the plug 3 is accommodated in the housing 1, the pins 6 and 6 that tend to move out of the housing cannot pass through between the projections 15 and 15 to be in a half-locked state.

In the above-described example, a shape of the pin holder 7 of the plug 3 is given as a hexagon. However, the present invention is not limited to this. 0038

In addition, it is a matter of course that also the shape and the structure of the plug locker 4 are not limited to those in the above example.

### Industrial Applicability

As explained above, the AC charger according to the present invention can make a plug stand when used and make the plug accommodated in a housing when not used. Therefore, the shape in time of being not used becomes of rectangular to be handy to carry. In addition, the simple structure allows the charger to be provided as being inexpensive.

## Claims

1. An AC charger **characterized by** comprising a rectangular housing having an opened ceiling and a vertically bisected interior, a plug for being plugged in an AC receptacle, said plug being pivotally supported in an upper half interior of said housing for being allowed to be freely made stand and laid so as to be laid to be accommodated in said housing when not used and made stand to be projected upward from said housing when used, an AC to DC converting electric apparatus provided in a lower half interior of said housing, connection means for electrically connecting said AC to DC converting electric apparatus and said plug, and means for distributing a DC voltage outputted from said AC to DC converting electric apparatus to other electronic devices.

2. The AC charger as claimed in claim 1 **characterized in that** said plug has two pins for being plugged in the receptacle and a pin holder for embedding bases of said two pins, a rear end part of said pin holder being formed in a semicylindrical form and being pivotally supported by right and left side walls of the housing in being rotatable with an axis of said cylinder at the center.

3. The AC charger as claimed in claim 1 or 2 **characterized by** comprising plug locking means for pressing the semicylindrical rear end part of said plug by a spring force when said plug is made stand.

4. The AC charger as claimed in claim 3 **characterized by** comprising lock-releasing means for releasing a lock to the standing plug by removing a pressing force of said spring of said plug locking means.

5. The AC charger as claimed in claim 3 or 4 **characterized in that** said plug locking means comprises two pieces arranged in parallel, and a pair of S-shaped leaf springs providing connection between said two pieces, one of said two pieces being secured to a rear part of said housing, and the other piece being movable backward and forward.

6. The AC charger as claimed in claim 5 **characterized in that** said lock releasing means comprises a lug attached to an upper face of the movable piece of said plug locking means.

7. The AC charger as claimed in claim 1 **characterized by** comprising means for holding the plug in time of being accommodated, said means comprising two hemisphere-like projections respectively formed on inside surfaces of right and left side walls of said housing so that their mutual distance is taken as being a little larger than a distance between outer sides of said two pins.

8. The AC charger as claimed in claim 1 **characterized in that** the connection means for electrically connecting said AC to DC converting electric apparatus and said plug is provided with two contacting pieces arranged on a surface of the semicylindrical rear end part of said plug and respectively connected to said two pins.
